# EUROPÄISCHE PATENTSCHRIFT

(11) **EP 2 609 620 B1**
(45) Veröffentlichungstag und Bekanntmachung des Hinweises auf die Patenterteilung: **13.05.2020**
(21) Anmeldenummer: 11743799.6
(22) Anmeldetag: 13.07.2011
(51) Int. Cl.: H01L 23/373, H01L 23/433, H01L 21/48, H05K 7/20, H01L 25/07

(54) **VERFAHREN ZUR HERSTELLUNG EINER ELEKTRISCHEN SCHALTUNG UND ELEKTRISCHE SCHALTUNG**
METHOD FOR PRODUCING AN ELECTRICAL CIRCUIT AND ELECTRICAL CIRCUIT
PROCÉDÉ DE RÉALISATION D'UN CIRCUIT ÉLECTRIQUE ET CIRCUIT ÉLECTRIQUE

(30) Priorität: 25.08.2010 DE 102010039728
(43) Veröffentlichungstag der Anmeldung: 03.07.2013
(73) Patentinhaber: Robert Bosch GmbH, 70442 Stuttgart (DE)
(72) Erfinder: GEINITZ, Eckart, 72793 Pfullingen (DE)
(86) Internationale Anmeldenummer: PCT/EP2011/061979
(87) Internationale Veröffentlichungsnummer: WO 2012/025294

(56) Entgegenhaltungen:
- EP-A1- 1 921 675
- EP-A2- 0 827 198
- EP-A2- 1 061 783
- EP-A2- 1 453 089
- EP-A2- 1 482 771
- EP-A2- 1 518 847
- DE-A1- 10 331 857
- DE-A1-102007 049 481
- JP-A- 2009 124 082
- US-A1- 2005 221 538
- US-A1- 2006 258 055
- US-A1- 2007 145 540
- US-A1- 2010 127 371

## Beschreibung

### Stand der Technik

Es ist bekannt, zur Abfuhr von Verlustwärme elektrischer oder elektronischer Komponenten Kühlkörper zu verwenden, die über eine Leiterplatte oder ein Substrat mit den Komponenten wärmeleitend verbunden sind. Die Wärme wird zunächst von der Wärmequelle, d.h. der Komponenten, auf die Leiterplatte übertragen, auf der diese montiert sind. Die Wärme wird von der Leiterplatte an den Kühlkörper weitergeleitet.

Sogenannte isolierende Metallsubstrate (IMS, insulated metal substrate) weisen zur besseren Wärmeabfuhr eine dicke Metallplatte auf, die an den Kühlkörper montiert wird, während eine Kupferkaschierung, die über ein Dielektrikum mit der Metallplatte verbunden ist, Leiterbahnen zum für die darauf zu montierenden elektrischen Komponenten vorsieht. Die Kupferkaschierung ist dünn (max. 300 µm) ausgestaltet, damit die Leiterbahnen durch Strukturierung der Kupferkaschierung ausgebildet werden können, insbesondere durch Photolithographie und anschließendem Ätzen. Es ist daher ein notwendigerweise auftretender Nachteil bei dieser Anordnung, dass die Kupferkaschierung, an die die Komponenten montiert sind, aufgrund ihrer geringen Dicke die Wärme nicht ausreichend spreizen kann, zumal das darauffolgende Dielektrikum materialbedingt eine geringe Wärmeleitfähigkeit aufweist. Bei hoher Wärmebelastung ergibt sich durch den Isolationseffekt des Dielektrikums und durch die geringe Wärmespreizung durch das Kupferkaschierung ein punktueller Wärmestau ("Hot Spot") an der Montagestelle der Komponente.

In der Druckschrift DE 103 31 857 B4 ist eine Leistungshalbleitervorrichtung dargestellt, in der eine dickere Metallplatte einen Leistungshalbleiter (= Wärmequelle) trägt. Die Metallplatte ist auf einem vereinten Komplex aus einer Isolierharzschicht und einer dünneren Metallschicht angeordnet, wobei dieser vereinte Komplex mit der Isolierschicht voran auf der Metallplatte angeordnet wird und durch wärmebeaufschlagte Druckbehandlung mit der Metallplatte verbunden wird, die hierbei bereits in Gussmaterial

eingebettet ist. Hierbei steht der Komplex weit über die dickere Metallplatte hinaus und wird in Randbereichen zudem mit dem Gussmaterial verbunden.

Der so vorgesehene schrittweise Herstellungsprozess erfordert zahlreiche Schichtverbindungsschritte, wobei zumindest das Befestigen des Komplexes mit der restlichen Schaltung (als einer dieser Schritte) mit bereits vollkommen bestückten Schaltungskomponenten ausgeführt wird. Daher sind Druck und Temperatur begrenzt, wobei ferner die Schaltung durch Druck und Temperatur belastet wird. Zudem kann mit der schrittweisen Befestigung der Schichten aneinander nicht die erwünschte temperaturbelastbare Anordnung erreicht werden, da Restluft zwischen den Schichten durch die einzelnen Schichtfertigungsschritte vorliegen kann, die einen Hot Spot erzeugt. Schließlich sind die einzelnen Komponenten keine als Massenware gefertigten Standartbauteile, so dass neben den Kosten der komplexen Herstellung auch die Bauteilkosten hoch sind.

Das Dokument US 2007/0145540 A1 offenbart eine Halbleitervorrichtung mit Halbleiterbauelementen, Elektroden, einem isolierenden Substrat und Metallschichten, die als Stapel in einem Harzguss angeordnet sind.

Die Druckschrift JP 2009-124082 A beschreibt eine Halbleitervorrichtung, bei der ein Halbleiterelement mit einer Kühlfläche auf einem Keramiksubstrat angeordnet ist, wobei das Keramiksubstrat auf einer Aluminiumbasisplatte angeordnet ist.

Das Dokument EP 1 061 783 A2 beschreibt ein Keramikmehrfachsubstrat, das aus einer Keramikschicht besteht, die mit Metallisierungen versehen ist.

Es ist eine Aufgabe der Erfindung, eine elektrische Schaltung und ein Herstellungsverfahren hierfür vorzusehen, die bzw. das eine einfachere und kostengünstigere Produktion erlaubt und die bzw. das eine erhöhte Wärmeabführung ermöglicht.

### Offenbarung der Erfindung

Diese Aufgabe wird gelöst durch die Gegenstände der unabhängigen Ansprüche.

Die Erfindung ermöglicht die Verwendung von kostengünstigen Standardbauteilen und eine Verringerung der erforderlichen Prozessschritte. Ferner wird eine belastbarere und effizientere Wärmeabführung geschaffen. Zudem ist die erzeugte Schaltung ausfallsicherer, da während der Anordnung der Wärmeabführungskomponenten die Schaltungskomponenten keiner Erwärmung und keinem Druck ausgesetzt werden. Schließlich ermöglicht die Erfindung, die elektrische Durchschlagsfestigkeit der wärmeabführenden Schichten zu testen, ohne dass weitere Komponenten den Durchschlagstest stören können bzw. der Durchschlagstest die elektrischen Bauteile der Schaltung gefährdet.

Erfindungsgemäß wird ein vorgefertigtes Substrat verwendet, das eine erste und eine zweite Leiterschicht umfasst, die von einem Dielektrikum getrennt sind. Die erste Leiterschicht ist um ein Vielfaches dicker als die zweite Leiterschicht und dient zur Wärmeaufnahme direkt von einem darauf montierten Bauteil, das eine Wärmequelle darstellt und zu kühlen ist. Durch die hohe Dicke der ersten Leiterschicht wird die entstehende Wärme weit aufgespreizt. Die erste Leiterschicht dient im Wesentlichen der Wärmeübertragung. Die zweite Leiterschicht dient insbesondere dem Schutz des Dielektrikums und kann gegebenenfalls zur Verschaltung dienen und in Leiterbahnen strukturiert sein. Durch den Schutz ist es möglich, dass das Dielektrikum als dünne, isolierende Schicht ausgebildet werden kann, die insbesondere aufgrund der geringen Dicke eine hohe Wärmeleitfähigkeit erlaubt. Die zweite Leiterschicht schützt während der Herstellung (und der späteren Montage) das Dielektrikum vor mechanischen Einflüssen. Das auf die erste Leiterschicht folgende Dielektrikum kann den weit aufgespreizten Wärmefluss mit großer Durchgangsoberfläche an die zweite Leiterschicht übertragen. Die zweite Leiterschicht dient zur Kontaktierung eines Kühlkörpers (oder einer Wärmebrücke, die zu einem Kühlkörper führt). Bei der Herstellung der erfindungsgemäßen Schaltung unter Anwendung des erfindungsgemäßen Verfahrens zur Herstellung wird von einem vorgefertigten Substrat ausgegangen, dessen Schichtstruktur bereits fertiggestellt ist. Ein derartiges Substrat wird gemäß üblicher Verfahren zur Herstellung von Leiterplatten bzw. Substrate erzeugt, wobei bei der Herstellung (mangels weiterer Komponenten) Drücke und Temperaturen verwendet werden, die nur die Eigenschaften des Substrats zu berücksichtigen haben. Insbesondere können höhere Temperaturen, Drücke oder weitere Herstellungsparameter verwendet werden, die andere Komponenten wie Gussmaterialien zur Schaltungseinbettung, Halbleiterbauelemente oder Wärmepasten nachhaltig beeinträchtigen würden.

Die erste Leiterschicht ist eine Metallplatte, insbesondere aus Cu, Al, einer Cu-Legierung, einer AI-Legierung oder aus einem anderen wärmeleitenden Material. Die erste Leiterschicht dient als Träger. Die erste Leiterschicht kann eine Dicke von 0,5 - 10 mm, 0,8 - 8 mm, 1 - 5 mm oder 1 - 3 mm aufweisen. Die Dicke der ersten Leiterschicht beträgt insbesondere mindestens 0,5, 0,8, 1 oder 2 mm. Dies ermöglicht eine hohe Wärmespreizung der Wärme, die von dem direkt darauf montiertem zu kühlenden Bauteil ausgeht.

Die zweite Leiterschicht ist eine Metallkaschierung, insbesondere aus Kupfer. Die Dicke der zweiten Leiterschicht beträgt 0,03 - 0,45 mm, insbesondere 0,07 - 0,3 mm. Die Dicke der zweiten Leiterschicht beträgt nicht mehr als 0,4 oder 0,2 mm. Auch wenn die Erfindung nicht notwendigerweise Strukturen in der zweiten Leiterschicht vorsieht, so wird die Dicke dennoch so gewählt, dass übliche photolithographische Verfahren oder Fräsverfahren zur Strukturierung möglich sind, um auf Komponenten zurückgreifen zu können, die auch für andere Zwecke verwendet werden, und die somit als Massenware günstig herzustellen sind.

Das Dielektrikum ist aus einem elektrisch isolierenden Material, insbesondere aus einer Epoxyharzschicht oder einem anderen wärmeleitendem, isolierenden Klebstoff. Die Dicke des Dielektrikums, das als allgemeine Schicht ausgebildet ist, beträgt vorzugsweise 0,03 - 0,3 mm, insbesondere 0,075 - 0,2 mm. Das Dielektrikum ist eingerichtet, während der Herstellung des Substrats von einem fließfähigen Zustand in einen elastischen Zustand überzugehen durch chemische oder physikalische Aushärtung oder durch Erstarren aufgrund Erkaltens. Die erste Leiterschicht, das Dielektrikum und die zweite Leiterschicht werden bei Fertigung des Substrats aufeinander gepresst, während das Dielektrikum fließfähig ist. Es ergibt sich eine zähe, zumindest teilweise elastische Verbindung zwischen den Leiterschichten durch das Dielektrikum, so dass das erfindungsgemäß verwendete Substrat mechanisch robust ist. Das erfindungsgemäß verwendete Substrat zeichnet sich ferner dadurch aus, dass während dessen Herstellung die Schichten unter Vakuum zusammengepresst (und ggf. erwärmt) sind. Dadurch weist das Substrat eine gute Wärmeleitfähigkeit durch das Dielektrikum hindurch auf, da Restluft zwischen allen Schichten entfernt ist. Dadurch werden Hot Spots vermieden. Ferner wird durch die Materialwahl des Substrats (insbesondere durch elastische Eigenschaften des Dielektrikums) erreicht, dass das Substrat im Gegensatz zu keramikbasierten Leiterplatten mechanische Belastungen aufnehmen kann, ohne Schaden zu nehmen.

Die erfindungsgemäß vorgesehene elektrische Schaltung ist vorzugsweise eine Leistungsschaltung, insbesondere für den Automobilbereich. Die zu kühlendenden Bauelemente sind vorzugsweise Leistungshalbleiter, beispielsweise Transistoren, IGBTs, Dioden, FETs, Bipolartransistoren, Thyristoren, TRIACs oder auch andere Bauelemente mit hoher Verlustleistung wie Widerstände, Drosseln oder Transformatoren. Die Bauelemente können ferner getaktete Bauelemente mit hoher Wärmeabgabe sein, beispielsweise Prozessoren oder Controller. Die Erfindung wird insbesondere für Steuerschaltungen, Endstufen oder Treiberschaltungen im Automobilbereich eingesetzt, beispielsweise für Motorsteuerungen oder Elektroantrieb-Steuerungen.

Die Erfindung sieht daher ein Verfahren zur Herstellung einer elektrischen Schaltung vor, wobei zunächst ein vorgefertigtes Substrat mit einer ersten und einer zweiten Leiterschicht sowie einem Dielektrikum vorgesehen wird. Das Substrat befindet sich zwischen der ersten und der zweiten Leiterschicht. Die erste Leiterschicht ist um ein Vielfaches dicker als die zweite Leiterschicht. Das Vielfache kann von 3 bis 350 oder vorzugsweise von 3 - 100 reichen und ist allgemein eine reelle Zahl. Es wird zumindest ein zu kühlendes Bauteils auf der ersten Leiterschicht des vorgefertigten Substrats montiert. Eine wärmeübertragende Verbindung zwischen dem Bauteil und der ersten Leiterschicht wird durch die Montage ausgebildet. Bauteil und erste Leiterschicht werden direkt miteinander verbunden, d.h. durch direkten Kontakt, vorzugsweise über einen unmittelbaren, physischen Kontakt und/oder eine stoffschlüssige Verbindung wie eine Lötverbindung, bei der eine dünne Lötschicht den direkten Kontakt herstellt. Bestimmte Ausführungen können es erfordern, dass der Kontakt über eine dünne Schicht Wärmeleitmaterial (d.h. Wärmeleitpaste oder ein Wärmeleitpad) vorgesehen wird. Aufgrund der hohen Wärmeleitung mittels dieser Kontakte können die vorgehend beschriebenen Kontakte als direkte Kontakte angesehen werden.

Gemäß einem besonderen Aspekt der Erfindung wird das vorgefertigte Substrat vorgesehen als (vorzugsweise unter Vakuum) miteinander verbundener Stapel der ersten Leiterschicht, dem Dielektrikum und der zweiten Leiterschicht. In einer einfach zu realisierenden Variante wird das Substrat als sogenannte Metallkern-Leiterplatte vorgesehen, wobei weitere Bezeichnungen IMS (isolated metal substrate), isoliertes Metallsubstrat, oder als Metallträger mit (unter Vakuum) auflaminierter Leiterplatte lauten. Derartige IMS sind weitreichend bekannt und werden in hohen Stückzahlen zu geringen Kosten gefertigt. Diese werden als Ausgangsmaterial für die erfindungsgemäße Schaltung bzw. das erfindungsgemäße Verfahren verwendet. Anstatt der üblichen Nutzung, bei der die Bauelemente auf die dünnere, zweite Schicht montiert werden, sieht die Erfindung vor, die zu kühlenden Bauelemente auf die dickere Leiterschicht zu montieren, damit diese die Wärme ungehindert über die gesamte dicke der ersten Leiterschicht spreizen kann. Erfindungsgemäß wurde erkannt, dass die übliche Nutzung eine Übertragung des noch ungespreizten Wärmeflusses über das Dielektrikum zu punktueller Wärmeakkumulation führen kann, wobei erfindungsgemäß dieser Nachteil überwunden wird, indem die Bauelemente auf die dickere, erste Leiterschicht montiert werden. Ein Hauptaspekt der Erfindung ist daher die Verwendung eines üblichen IMS in umgedrehter Weise, bei der die Bauelemente auf die dickere Leiterschicht montiert werden. Die dünnere Schicht, die im Stand der Technik auch für Leiterbahnen verwendet wird, dient erfindungsgemäß als Kontaktfläche für Kühlkörper.

Einer weitere Ausführungsform des erfindungsgemäßen Verfahrens sieht vor, dass das Montieren des zumindest einen zu kühlenden Bauteils ferner umfasst: Ausbilden eines elektrischen Kontakts zwischen dem Bauteil und der ersten Leiterschicht, insbesondere durch Löten eines zur ersten Leiterschicht zugewandten Kontakts des Bauelements auf die dem Bauteil zugewandten Oberfläche der ersten Leiterschicht. Es können auch andere Verfahren zur Herstellung einer elektrischen Verbindung verwendet werden, bsp. Klemmen, Flanschen oder eine Schraubkontaktierung. Die erste, dickere Leiterschicht dient daher neben der Wärmeabfuhr auch der elektrischen Kontaktierung der Bauelemente. Daher kann auch vorgesehen sein, eine elektrische Verbindung mit der ersten Leiterschicht herzustellen, beispielsweise mittels einer Lötverbindung, durch einen auf die erste Leiterschicht drückenden Kontakt oder durch Bonden. Insbesondere kann ein federnder Leiterbügel verwendet werden, der auf die erste Leiterschicht pressend oder auf eine obere Kontaktfläche des Bauteils pressend angeordnet wird.

Weiterhin ist vorgesehen, dass das Substrat vor oder nach dem Montieren des mindestens einen Bauteils strukturiert wird durch Trennen einzelner Substratabschnitte durch die gesamte Dicke des Substrats hindurch. Das Substrat wird daher in einzelne, körperlich zunächst getrennte Substratabschnitte unterteilt. Mit dieser Vorgehensweise sind individuelle elektrische Verbindungen möglich, wie sie ansonsten von Leiterbahnen vorgesehen werden. Daher wird ferner eine elektrische Verbindung zwischen dem Substratabschnitt einerseits und einer elektrischen Kontaktschnittstelle oder einem weiteren Substratabschnitt ausgebildet. Die Verbindungen werden von den oben genannten Maßnahmen vorgesehen, insbesondere durch einen gelöteten oder in Federkontakt gehaltenen Bügel, der die erste Leiterschicht des Substratabschnitts oder einen oberen Kontakt des Bauteils kontaktiert, und ferner mit einer Kontaktstelle einer elektrischen Schnittstelle, oder einer ersten Leiterschicht oder einem oberen Kontakt eines Bauteils eines weiteren Substratabschnitts in gleicher Weise verbunden wird. Zumindest einer der Substratabschnitte trägt zumindest ein Bauteil.

Zwischen dem zumindest einen Bauteil und einer elektrischen Kontaktschnittstelle oder zwischen dem Bauteil und einem weiteren, auf der ersten Leiterschicht montierten Bauteil kann eine elektrische Verbindung erzeugt werden durch Bonden mindestens eines Leiters, durch Löten oder durch Anlöten eines Leiters, insbesondere einer Metallbrücke. Die Kontaktschnittstelle entspricht der elektrischen Schnittstelle zur Anbindung externer Komponenten.

Weiterhin kann das Verfahren vorsehen, dass zumindest ein Teil des Substrats und das zumindest eine Bauteil eingegossen wird (durch Einbetten in einen spritzfähigen Kunststoff, insbesondere durch ein Spritzgußverfahren). Dies wird insbesondere vorgesehen, wenn Substratabschnitte verwendet werden, wobei die Substratabschnitte nach dem Montieren des mindestens einen Bauteils eingegossen werden. Die erfindungsgemäße Schaltung umfasst daher gemäß diesem Aspekt eine Gussmasse, in der zumindest ein Teil des Substrats (insbesondere die erste Schicht) und das zumindest eine Bauteil eingebettet sind. Werden Verbindungen zwischen Substrat(-abschnitt) und einer elektrischen Schnittstelle oder zwischen Substratabschnitten verwendet, dann werden bzw. sind diese vorzugsweise ebenso eingegossen.

Die einzelnen Substratabschnitte des Substrats werden voneinander getrennt durch Stanzen, durch Sägen, durch Schneiden, durch Lasertrennen, oder durch Ritzen (vorzugsweise beidseitig) und Brechen. Alternativ oder in Kombination hiermit wird ferner eine Wärmesenke vorgesehen, auf die die einzelnen Substratabschnitte montiert werden. Durch die Montage werden wärmeübertragende Verbindungen zwischen den zweiten Leiterschichten des Substrats und der der Wärmesenke ausgebildet. Die Wärmesenke kann von einer Metallplatte vorgesehen sein, auf der einige oder alle Substratabschnitte der Schaltung angeordnet sind. Die wärmeübertragende Verbindung wird durch direkten Kontakt zwischen zweiter Leiterschicht und Wärmesenke vorgesehen (ggf. unterstützt von einer Schicht aus Wärmeleitpaste). Die Wärmesenke kann ebenso von einem Kühlkörper mit Kühlfingern vorgesehen sein, der eine Kontaktfläche zur Wärmeaufnahme umfasst, wobei die zweite Leiterschicht mit dieser wärmeübertragend verbunden wird.

In einer alternativen Ausführungsform wird nicht das gesamte Substrat sondern nur die erste Leiterschicht strukturiert, d.h. in elektrisch voneinander getrennte Abschnitte eingeteilt, beispielsweise mittels Fräsen oder durch Vorsehen eines vorgefertigten Substrats, das bereits eine strukturierte erste Leiterschicht aufweist. Die einzelnen Abschnitte der ersten Leiterschicht sind durch das Dielektrikum und die zweite Leiterschicht in festen Positionen zueinander angeordnet. Da die Strukturierung von der Schaltung abhängen kann, ist diese Variante insbesondere für Serienfertigung der gleicher (oder gleichartiger) Schaltungen vorgesehen.

Gemäß einer weiteren Ausführungsform wird ein Randbereich der zweiten Leiterschicht entfernt, insbesondere durch Ätzen oder Fräsen. In dem Randbereich wird die zweite Leiterschicht über ihre gesamte Dicke entfernt. Dadurch wird ein Überstand des Dielektrikums gegenüber der zweiten Leiterschicht in dem Randbereich erzeugt. Die erfindungsgemäße Schaltung weist in gleicherweise einen Randbereich auf, an dem das Dielektrikum seitlich über die zweite Leiterschicht hinausgeht und somit einen Überstand bildet. Dies dient zur sicheren elektrischen Trennung von erster Leiterschicht und zweiter Leiterschicht (bzw. Wärmesenke).

Gemäß einer weiteren Ausführungsform wird das vorgefertigte Substrat als ein Substrat vorgesehen wird, dessen elektrische Durchschlagsfähigkeit gemessen wurde, beispielsweise in Rahmen der Endkontrolle eines vorangehenden Substrat-Herstellungsverfahrens, dessen Endprodukt das erfindungsgemäß verwendete Substrat ist. Dadurch ist die Ausschussrate des erfindungsgemäßen Herstellungsverfahrens verringert. Alternativ kann das Vorsehen des Substrats umfassen: Ermitteln der Durchschlagsfestigkeit durch Anlegen einer Probespannung zwischen der ersten und der zweiten Leiterschicht und Erfassen eines Messstroms, vorzugsweise vor dem Montieren der Bauteile. Dadurch kann der Schichtaufbau während der Herstellung der elektrischen Schaltung bereits getestet werden, wobei bei fehlerhaften Subtraten diese vor der Montage der Bauteile (und vor dem Vergießen) verworfen werden. Dadurch werden Kosten durch Ausschuss reduziert.

Die Erfindung wird ferner realisiert mittels einer elektrischen Schaltung. Die Merkmale der Schaltung entsprechenden den zugehörigen Merkmalen der Schaltungskomponenten wie sie oben beschrieben sind bzw. wie sie sich durch die oben beschriebene Vorgehensweisen ergeben. Dies gilt insbesondere für das Substrat, das Bauelement, Substratabschnitte, usw. Die erfindungsgemäße elektrische Schaltung umfasst ein vorgefertigtes Substrat, das mit einer ersten und einer zweiten Leiterschicht sowie einem dazwischenliegendem Dielektrikum hergestellt ist. Durch die Vorabfertigung (unter Fertigungsparametern, die bei bestückten Komponenten nicht einzuhalten sind) erhält das Substrat eine hohe Wärmeleitfähigkeit und Elastizität. Ferner sind die Bauelemente (da nicht den Fertigungsparametern des Substrats unterworfen) nicht durch Druck- oder Wärmebelastung beeinträchtigt. Die erste Leiterschicht ist um ein Vielfaches dicker als die zweite Leiterschicht. Die Schaltung umfasst ferner zumindest ein zu kühlendes Bauteil, das auf der ersten Leiterschicht montiert ist. Zwischen dem Bauteil und der ersten Leiterschicht ist eine wärmeübertragende Verbindung vorgesehen, vorzugsweise durch direkten Kontakt, der von einer Lötverbindung, d.h. einer dünnen Lötschicht zwischen Bauteil und erste Leiterschicht vorgesehen wird. Der direkte Kontakt kann insbesondere durch einen unmittelbaren physischen Kontakt hergestellt werden. Alternativ kann der Kontakt von einer Wärmepaste unterstützt sein kann, die eine Wärmeleitschicht vorsieht. Der direkte Kontakt sieht eine hohe Wärmeübertragung zwischen Bauteil und der ersten Leiterschicht vor.

Eine Ausführungsform der erfindungsgemäßen elektrischen Schaltung sieht vor, dass das Substrat in mehrere individuelle, getrennte Substratabschnitte aufgeteilt ist. Auf mindestens zwei der Substratabschnitte ist mindestens ein zu kühlendes Bauteil angeordnet. Die Substratabschnitte sind auf einer Wärmesenke befestigt. Diese ist wärmeübertragend mit der zweiten Leiterschicht der Substratabschnitte verbunden (vorzugsweise über direkten Kontakt, ggf. unterstützt von Wärmeleitpaste). Die Substratabschnitte sowie das mindestens eine Bauteil sind in einer Gußmasse eingebettet. Die Gußmasse ist aus einem elektrisch isolierenden Kunststoffmaterial, vorzugsweise einem spritzgussfähigem Kunststoffmaterial. Es können, wie oben beschrieben, elektrische Verbindungen (Metallbrücken, Lötverbindungen, Bondingverbindungen oder eine Kombination hiervon), in der Schaltung vorgesehen sein, um die Substratabschnitte untereinander und/oder einen Substratabschnitt mit einer Kontaktschnittstelle (wie oben beschrieben) zu verbinden.

Alternativ kann die erste Leiterschicht in Abschnitte unterteilt sein, die voneinander elektrisch getrennt sind, wobei die Abschnitte mit dem Dielektrikum mechanisch fest verbunden sind. Die erste Leiterschicht kann in Form eines Stanzgitters zusammen mit dem Dielektrikum und der zweiten Leiterschicht ausgebildet sein.

### Kurze Beschreibung der Zeichnungen

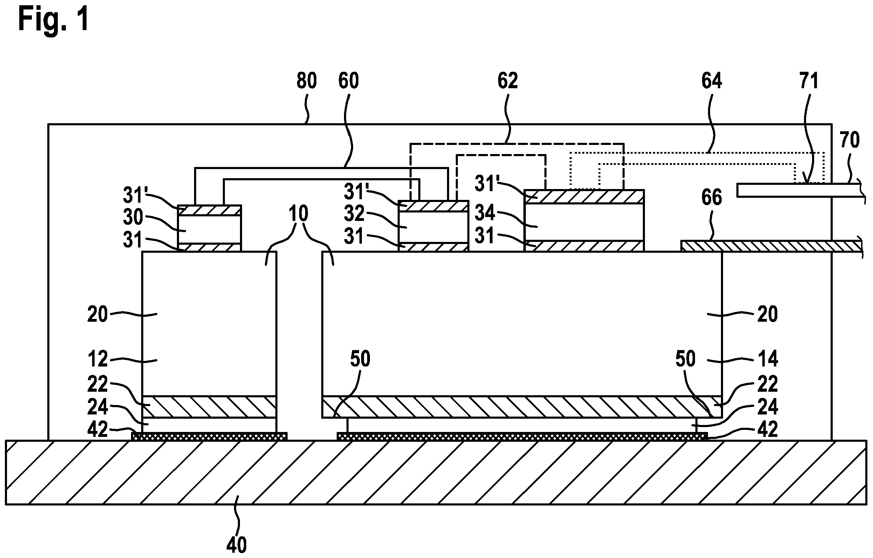

Die Figur 1 zeigt eine beispielhafte erfindungsgemäße elektrische Schaltung in Schnittdarstellung.

### Ausführungsformen der Erfindung

Die in Figur 1 dargestellte beispielhafte erfindungsgemäße Schaltung umfasst ein Substrat 10, das in zwei Abschnitte 12, 14 eingeteilt ist. Das Substrat umfasst eine erste Leiterschicht 20, ein schichtförmiges Dielektrikum 22, und eine zweite Leiterschicht 24. Auf der ersten Leiterschicht 20 sind Bauelemente 30, 32, 34 montiert durch Lötverbindungen. Die zweite Leiterschicht 24 aller Abschnitte ist auf eine gemeinsame Wärmesenke in Form einer Metallplatte 40 über Lötverbindungen 42 befestigt; für jeden Abschnitt ist eine Lötverbindung 42 vorgesehen. Eine alternative wärmeübertragende Anbindung 42 wäre eine elektrisch isolierende, wärmeübertragende Verbindung in Form einer Schicht aus Wärmeleitkleber.

Die zweite Leiterschicht 24 ist gegenüber dem Dielektrikum hinterschnitten, so dass Überstände 50 vorgesehen sind.

Jedes Bauelement 30 - 34 weist eine obere und eine untere Kontaktfläche auf. Die untere Kontaktfläche 31 ist direkt auf die erste Leiterschicht 20 aufgelötet, um mit dieser eine wärmeübertragende Verbindung vorzusehen. Die oberen Kontaktfläche 31' der Bauelemente 32- 34 sind über Kontaktbrücken aus Metall angeschlossen. Die Kontaktbrücke 60 verbindet den oberen Kontakt 31' des Bauteils 30 mit dem oberen Kontakt 31' des Bauteils 32, wobei die beiden Bauteile 30 und 32 auf unterschiedlichen Abschnitten 12, 14 des Substrats 10 vorgesehen sind. Die Kontaktbrücke 62, gestrichelt dargestellt, verbindet die oberen Kontaktfläche 31' des Bauteils 30 mit der oberen Kontaktfläche 31' des Bauteils 32, wobei die beiden Bauteile 30 und 32 auf dem selben Abschnitt 14 des Substrats 10 vorgesehen sind. Falls die unteren Kontakte 31 der Bauteile 32 und 34 elektrisch aktiv sind, so werden diese über die erste Leiterschicht 20 und über die Lötverbindungen zwischen den unteren Kontakten 31 der Bauteile 32 und 34 der ersten Leiterschicht 22 des Abschnitts 14 miteinander verbunden.

Eine weitere elektrische Verbindung besteht über die Kontaktbrücke 64 (gepunktet dargestellt), der den oberen Kontakt 31' des Bauelements 34 mit einer Kontaktschnittstelle 70 herstellt. Die Kontaktbrücke 64 kann (wie auch andere Kontaktbrücken der Schaltung) über Lötverbindungen mit den jeweiligen Kontaktflächen verbunden sein oder kann elastische Eigenschaften aufweisen, von einem nicht dargestellten Element in nach unten zu dem Substrat hin gedrückt werden, und über den resultierenden Presskontakt mit den Kontaktflächen verbunden sein. Die Kontaktschnittstelle 70 weist eine Kontaktfläche 71 zur Kontaktierung der Brücke auf und erstreckt sich durch eine Außenseite der Schaltung zum Abschluss externer Komponenten (Sensoren, Stromversorgung...). Weiterhin können die Bauelemente Steuereingänge (nicht dargestellt) aufweisen, die insbesondere über Bondingverbindungen (nicht dargestellt) kontaktiert sind. Die in Figur 1 dargestellten elektrischen Verbindungen (Kontaktbrücken 60 - 66) sind Hochstromverbindungen, die zum Transport von Leistungsströme eingerichtet sind, insbesondere durch Ihren Querschnitt (und ihr Material, Cu oder AI). Schließlich besteht eine weitere elektrische Verbindung in Form einer Kontaktbrücke 66, die eine Kontaktfläche aufweist, die direkt auf der ersten Leiterschicht 20 des Abschnitts 14 des Substrats 10 angeschlossen ist. Die Kontaktbrücke kann durch eine Lötverbindung mit der ersten Leiterschicht 20 verbunden sein.

Die Schaltung ist in einem Gussmaterial 80 eingebettet, wobei bis auf die Kontaktschnittstelle 70 und die Kontaktbrücke 66 (sowie die Metallplatte 40) alle Komponenten von dem Gussmaterial 80 eingebettet sind. Die Kontaktschnittstelle 70 und die Kontaktbrücke 66 ragen durch die Außenseite der Schaltung d.h. des Gussmaterials hindurch. Ferner weist die Metallplatte 40 eine Unterseite auf, die nicht von Gussmaterial bedeckt ist, wobei auf der entgegengesetzten Oberseite die restlichen Schaltungskomponenten angeordnet sind.

Bei der Herstellung der Schaltung nach Figur 1 wird zunächst das Substrat 10 vorgesehen, das geschnitten wird, um die Abschnitte 12 und 14 auszubilden. Die Bauelemente werden auf dem Substrat befestigt (vor bzw. bevorzugt nach dem Schneiden), und das Substrat wird bereits in Abschnitte aufgeteilt auf der Metallplatte 4 befestigt, die als verbindender Träger für die Abschnitte dient. Ferner werden die Kontaktbrücken 60 - 66 und die Kontaktschnittstelle 70 mit den Bauteilen bzw. mit der ersten Leiterschicht befestigt. Die Bauteile 30 - 34, die Kontaktbrücken 60 - 66 und die Kontaktschnittstelle 70 werden durch Löten befestigt. Nach dem Befestigen der Bauteile 30 - 34, der Kontaktbrücken 60 - 66 und der Kontaktschnittstelle 70 wird die Schaltung in das Gussmaterial 80 eingegossen. Ferner wird die Metallplatte 40 an die zweite Leiterschicht 24 mittels Wärmeleitpaste oder Wärmeleitkleber 42 wärmeübertragend angeschlossen. Die Metallplatte 40 bildet hierbei den Kühlkörper. Vorzugweise wird das Eingießen durchgeführt, nachdem die Metallplatte an die zweite Leiterschicht wärmeübertragend angeschlossen wurde. Während dem Eingießen sind die externen Bereich der Kontaktbrücke 66 und der Kontaktschnittstelle 70 (d.h. Bereiche, die sich von der späteren Außenseite der Schaltung weg erstrecken) nicht innerhalb einer Gussform, in die das Material eingegossen wird. Alternativ können diese Bereiche nach dem Gießen freigelegt werden.

## Patentansprüche

1. Verfahren zur Herstellung einer elektrischen Schaltung mit den Schritten: Vorsehen eines vorgefertigten Substrats (10) mit einer ersten und einer zweiten Leiterschicht (20, 24) sowie einem Dielektrikum (22), das zwischen der ersten und der zweiten Leiterschicht vorgesehen ist und die erste Leiterschicht (20) um mindestens einen Faktor 3 dicker als die zweite Leiterschicht (24) ist; Montieren zumindest eines zu kühlenden Bauteils (30 - 34) auf der ersten Leiterschicht (20) des vorgefertigten Substrats unter Ausbildung einer wärmeübertragenden Verbindung zwischen dem Bauteil und der ersten Leiterschicht, wobei das Substrat (10) vor oder nach dem Montieren des mindestens einen Bauteils (30 - 34) strukturiert wird durch Trennen einzelner Substratabschnitte (12, 14) durch die gesamte Dicke des Substrats hindurch, wobei zumindest einer der Substratabschnitte zumindest ein Bauteil trägt, ferner eine elektrische Verbindung zwischen dem Substratabschnitt (14) einerseits und einer elektrischen Kontaktschnittstelle (70) oder einem weiteren Substratabschnitt (12) ausgebildet wird, und die Substratabschnitte nach dem Montieren des mindestens einen Bauteils eingegossen werden, wobei die einzelnen Substratabschnitte (12, 14) voneinander getrennt werden durch Stanzen, durch Sägen, durch Schneiden, durch Lasertrennen, oder durch Ritzen und Brechen, wobei ferner eine Wärmesenke (40) vorgesehen wird, auf die die einzelnen Substratabschnitte montiert werden unter Ausbildung von wärmeübertragenden Verbindungen (42) zwischen den zweiten Leiterschichten (24) des Substrats und der Wärmesenke (40).

2. Verfahren nach Anspruch 1, wobei das vorgefertigte Substrat (10) vorgesehen wird als unter Vakuum miteinander verbundener Stapel der ersten Leiterschicht (20), dem Dielektrikum (22) und der zweiten Leiterschicht (24), als Metallkern-Leiterplatte bzw. isoliertem Metallsubstrat, IMS, oder als Metallträger mit unter Vakuum auflaminierter Leiterplatte.

3. Verfahren nach einem der vorangehenden Ansprüche, wobei das Montieren des zumindest einen zu kühlenden Bauteils (30 - 34) ferner umfasst: Ausbilden eines elektrischen Kontakts zwischen dem Bauteil (30 - 34) und der ersten Leiterschicht (20), insbesondere durch Löten eines zur ersten Leiterschicht zugewandten Kontakts des Bauelements auf die dem Bauteil zugewandten Oberfläche der ersten Leiterschicht.

4. Verfahren nach einem der vorangehenden Ansprüche, wobei zwischen dem zumindest einen Bauteil (30 - 34) und einer elektrischen Kontaktschnittstelle (70) oder zwischen dem Bauteil (32) und einem weiteren, auf der ersten Leiterschicht montierten Bauteil (34) eine elektrische Verbindung erzeugt wird durch Bonden mindestens eines Leiters, durch Löten oder durch Anlöten eines Leiters, insbesondere einer Metallbrücke (60 - 64).

5. Verfahren nach einem der vorangehenden Ansprüche, wobei ferner ein Randbereich der zweiten Leiterschicht entfernt wird, insbesondere durch Ätzen oder Fräsen, und ein Überstand (50) des Dielektrikums (22) gegenüber der zweiten Leiterschicht (24) in dem Randbereich erzeugt wird.

6. Verfahren nach einem der vorangehenden Ansprüche, wobei das vorgefertigte Substrat (10) als ein Substrat (10) vorgesehen wird, dessen elektrische Durchschlagsfähigkeit gemessen wurde , oder wobei das Vorsehen des Substrats umfasst: Ermitteln der Durchschlagsfestigkeit durch Anlegen einer Probespannung zwischen der ersten und der zweiten Leiterschicht und Erfassen eines Messstroms.

7. Elektrische Schaltung, umfassend: ein vorgefertiges Substrat (10), das mit einer ersten und einer zweiten Leiterschicht (20, 24) sowie einem dazwischenlegendem Dielektrikum (22) hergestellt ist, wobei die erste Leiterschicht (20) um mindestens einen Faktor 3 dicker als die zweite Leiterschicht (24) ist, und zumindest ein zu kühlendes Bauteil (30 - 34), das auf der ersten Leiterschicht (20) montiert ist, wobei zwischen dem Bauteil (30 - 34) und der ersten Leiterschicht (20) eine wärmeübertragende Verbindung vorgesehen ist, wobei das Substrat (10) vor oder nach dem Montieren des mindestens einen Bauteils (30 - 34) strukturiert ist durch Trennen einzelner Substratabschnitte (12, 14) durch die gesamte Dicke des Substrats hindurch, wobei zumindest einer der Substratabschnitte zumindest ein Bauteil trägt, ferner eine elektrische Verbindung zwischen dem Substratabschnitt (14) einerseits und einer elektrischen Kontaktschnittstelle (70) oder einem weiteren Substratabschnitt (12) ausgebildet ist, und die Substratabschnitte nach dem Montieren des mindestens einen Bauteils eingegossen sind, ferner eine Wärmesenke (40) vorgesehen ist, auf die die einzelnen Substratabschnitte montiert sind unter Ausbildung von wärmeübertragenden Verbindungen (42) zwischen den zweiten Leiterschichten (24) des Substrats und der Wärmesenke (40).

8. Elektrische Schaltung nach Anspruch 7, wobei das Substrat (10) in mehrere individuelle, getrennte Substratabschnitte (12, 14) aufgeteilt ist, wobei auf mindestens zwei der Substratabschnitten mindestens ein zu kühlendes Bauteil (30 - 34) angeordnet ist, die Substratabschnitte auf einer Wärmesenke (40) befestigt sind, die wärmeübertragend mit der zweiten Leiterschicht (24) der Substratabschnitte verbunden ist, und die Substratabschnitte (12, 14) sowie das mindestens eine Bauteil (30 - 34) in einer Gußmasse (80) eingebettet sind.

## Claims

1. Method for producing an electrical circuit, comprising the steps of: providing a prefabricated substrate (10) having a first and a second conductor layer (20, 24) and also a dielectric (22) which is provided between the first and the second conductor layer and the first conductor layer (20) is thicker than the second conductor layer (24) by at least a factor of 3; mounting at least one component (30-34) to be cooled on the first conductor layer (20) of the prefabricated substrate so as to form a heat-transmitting connection between the component and the first conductor layer, wherein the substrate (10), before or after the at least one component (30-34) is mounted, is structured by separating individual substrate sections (12, 14) through the overall thickness of the substrate, wherein at least one of the substrate sections supports at least one component, furthermore an electrical connection between the substrate section (14) on the one hand and an electrical contact interface (70) or a further substrate section (12) is formed, and the substrate sections are moulded after the at least one component is mounted, wherein the individual substrate sections (12, 14) are separated from one another by stamping, by sawing, by cutting, by laser cutting, or by scoring and breaking, wherein a heat sink (40) is further provided, the individual substrate sections being mounted on the said heat sink so as to form heat-transmitting connections (42) between the two conductor layers (24) of the substrate and the heat sink (40).

2. Method according to Claim 1, wherein the prefabricated substrate (100) is provided as a stack comprising the first conductor layer (20), the dielectric (22) and the second conductor layer (24), which are connected to one another under vacuum, as a metal core printed circuit board or insulated metal substrate, IMS, or as a metal support with a printed circuit board which is laminated on under vacuum.

3. Method according to either of the preceding claims, wherein mounting the at least one component (30-34) to be cooled further comprises: forming an electrical contact between the component (30-34) and the first conductor layer (20), in particular by soldering a contact of the structural element, which contact faces the first conductor layer, onto the surface of the first conductor layer, which surface faces the component.

4. Method according to one of the preceding claims, wherein an electrical connection is produced between the at least one component (30-34) and an electrical contact interface (70) or between the component (32) and a further component (34), which is mounted on the first conductor layer, by bonding at least one conductor, by soldering or by brazing a conductor, in particular a metal bridge (60-64).

5. Method according to one of the preceding claims, wherein furthermore an edge region of the second conductor layer is removed, in particular by etching or milling, and an excess length (50) of the dielectric (22) in relation to the second conductor layer (24) is formed in the edge region.

6. Method according to one of the preceding claims, wherein the prefabricated substrate (10) is provided as a substrate (10) of which the dielectric strength has been measured, or wherein providing the substrate comprises: ascertaining the dielectric strength by applying a test voltage between the first and the second conductor layer and detecting a measurement current.

7. Electrical circuit comprising: a prefabricated substrate (10) which is produced with a first and a second conductor layer (20, 24) and also a dielectric (22) which is situated therebetween, wherein the first conductor layer (20) is thicker than the second conductor layer (24) by at least a factor of 3, and at least one component (30-34) to be cooled which is mounted on the first conductor layer (20), wherein a heat-transmitting connection is provided between the component (30-34) and the first conductor layer (20), wherein the substrate (10), before or after the at least one component (30-34) is mounted, is structured by separating individual substrate sections (12, 14) through the overall thickness of the substrate, wherein at least one of the substrate sections supports at least one component, furthermore an electrical connection is formed between the substrate section (14) on the one hand and an electrical contact interface (70) or a further substrate section (12), and the substrate sections are moulded after the at least one component is mounted,
furthermore a heat sink (40) is provided, the individual substrate sections being mounted onto the said heat sink so as to form heat-transmitting connections (42) between the second conductor layers (24) of the substrate and the heat sink (40).

8. Electrical circuit according to Claim 7, wherein the substrate (10) is divided into a plurality of individual, separated substrate sections (12, 14), wherein a component (30-34) to be cooled is arranged on at least two of the substrate sections, the substrate sections are fastened on a heat sink (40) which is connected to the second conductor layer (24) of the substrate sections in a heat-transmitting manner, and the substrate sections (12, 14) and also the at least one component (30-34) are embedded in a potting compound (80).

## Revendications

1. Procédé de fabrication d'un circuit électrique, comprenant les étapes consistant à : prévoir un substrat préfabriqué (10) avec une première et une deuxième couche conductrice (20, 24) ainsi qu'un diélectrique (22) prévu entre la première et la deuxième couche conductrice, et la première couche conductrice (20) est plus épaisse que la deuxième couche conductrice (24) au moins d'un facteur 3 ; monter au moins un composant à refroidir (30 à 34) sur la première couche conductrice (20) du substrat préfabriqué en établissant une connexion thermoconductrice entre le composant et la première couche conductrice, le substrat (10) étant structuré avant ou après le montage dudit au moins un composant (30 à 34) par la séparation de portions de substrat individuelles (12, 14) à travers toute l'épaisseur du substrat, dans lequel au moins l'une des portions de substrat porte au moins un composant, en outre une connexion électrique est établie entre la portion de substrat (14) d'une part et une interface de contact électrique (70) ou une autre portion de substrat (12), et après le montage dudit au moins un composant, les portions de substrat sont noyées dans la masse, dans lequel les portions de substrat individuelles (12, 14) sont séparées les unes des autres par estampage, par sciage, par découpage, par séparation au laser ou par rainurage et rupture, dans lequel en outre un dissipateur thermique (40) est prévu sur lequel sont montées les portions de substrat individuelles en établissant des connexions thermoconductrices (42) entre les deuxièmes couches conductrices (24) du substrat et le dissipateur thermique (40).

2. Procédé selon la revendication 1, dans lequel le substrat préfabriqué (10) est prévu sous la forme d'un empilement de la première couche conductrice (20), du diélectrique (22) et de la deuxième couche conductrice (24) reliés sous vide, d'une carte de circuits imprimés à âme métallique ou de substrat métallique isolé, IMS, ou de support métallique avec une carte de circuits imprimés stratifiée sous vide.

3. Procédé selon l'une quelconque des revendications précédentes, dans lequel le montage dudit au moins un composant à refroidir (30 à 34) comprend en outre : l'établissement d'un contact électrique entre le composant (30 à 34) et la première couche conductrice (20), en particulier par le brasage d'un contact de l'élément de construction, tourné vers la première couche conductrice, sur la surface de la première couche conductrice, tournée vers le composant.

4. Procédé selon l'une quelconque des revendications précédentes, dans lequel entre ledit au moins un composant (30 à 34) et une interface de contact électrique (70) ou entre le composant (32) et un autre composant (34) monté sur la première couche conductrice, une connexion électrique est générée par la métallisation d'au moins un conducteur, par le brasage ou l'assemblage par brasage d'un conducteur, en particulier d'un pont métallique (60 à 64).

5. Procédé selon l'une quelconque des revendications précédentes, dans lequel en outre une zone marginale de la deuxième couche conductrice est retirée, en particulier par gravure ou fraisage, et un dépassement (50) du diélectrique (22) par rapport à la deuxième couche conductrice (24) est généré dans la zone marginale.

6. Procédé selon l'une quelconque des revendications précédentes, dans lequel le substrat préfabriqué (10) est prévu sous la forme d'un substrat (10) dont la capacité diélectrique a été mesurée, ou dans lequel le fait de prévoir le substrat comprend : la détermination de la rigidité diélectrique par l'application d'une tension d'essai entre la première et la deuxième couche conductrice et la détection d'un courant de mesure.

7. Circuit électrique, comprenant : un substrat préfabriqué (10) fabriqué avec une première et une deuxième couche conductrice (20, 24) ainsi qu'un diélectrique (22) intermédiaire, la première couche conductrice (20) étant plus épaisse que la deuxième couche conductrice (24) au moins d'un facteur 3, et au moins un composant à refroidir (30 à 34) monté sur la première couche conductrice (20), une connexion thermoconductrice étant prévue entre le composant (30 à 34) et la première couche conductrice (20), dans lequel le substrat (10) est structuré avant ou après le montage dudit au moins un composant (30 à 34) par la séparation de portions de substrat individuelles (12, 14) à travers toute l'épaisseur du substrat, dans lequel au moins l'une des portions de substrat porte au moins un composant, en outre une connexion électrique est établie entre la portion de substrat (14) d'une part et une interface de contact électrique (70) ou une autre portion de substrat (12), et après le montage dudit au moins un composant, les portions de substrat sont noyées dans la masse, en outre un dissipateur thermique (40) est prévu sur lequel sont montées les portions de substrat individuelles en établissant des connexions thermoconductrices (42) entre les deuxièmes couches conductrices (24) du substrat et le dissipateur thermique (40).

8. Circuit électrique selon la revendication 7, dans lequel le substrat (10) est divisé en plusieurs portions de substrat individuelles (12, 14) séparées, dans lequel, sur au moins deux des portions de substrat, au moins un composant à refroidir (30 à 34) est disposé, les portions de substrat sont fixées sur un dissipateur thermique (40) relié de manière thermoconductrice à la deuxième couche conductrice (24) des portions de substrat, et les portions de substrat (12, 14) ainsi que ledit au moins un composant (30 à 34) sont noyés dans une masse de remplissage (80).
